# EUROPEAN PATENT APPLICATION

(11) **EP 4 804 750 A1**
(43) Date of publication of application: **09.09.2026**
(21) Application number: 26150833.7
(22) Date of filing: 08.01.2026
(51) Int. Cl.: H10B 12/00, G11C 11/4097

(54) **SEMICONDUCTOR MEMORY DEVICE**

(30) Priority: 07.03.2025 KR 20250029958
(71) Applicant: Samsung Electronics Co., Ltd., Suwon-si, Gyeonggi-do 16677 (KR)
(72) Inventor: KIM, Yu Jin, 16677 Suwon-si (KR); HAN, Jin Woo, 16677 Suwon-si (KR); KIM, Ju Hyun, 16677 Suwon-si (KR); KIM, Hyeon Cheol, 16677 Suwon-si (KR)
(74) Representative: Marks & Clerk LLP

(57) **Abstract**

A semiconductor memory device includes cell and peripheral structures. The cell structure includes first local bit lines extending in a vertical direction and spaced apart in a first horizontal direction, second local bit lines extending in the vertical direction and spaced apart from the first local bit lines in a second horizontal direction, a first global bit line extending in the first horizontal direction and electrically connected to the first local bit lines, and a second global bit line extending in the first horizontal direction and electrically connected to the second local bit lines. The peripheral circuit structure includes a peripheral circuit transistor, a first transistor electrically connected to the peripheral circuit transistor and the first global bit line, and a second transistor electrically connected to the peripheral circuit transistor and the second global bit line. The semiconductor memory device is configured to selectively turn on the first and second transistors in a complementary manner.

## Description

### BACKGROUND

The present disclosure relates to a semiconductor memory device, and more specifically, to a three-dimensional semiconductor memory device.

It is advantageous to increase the degree of integration of semiconductor elements to satisfy excellent performance and low price required by consumers. In the case of the semiconductor elements, because the degree of integration is an important factor in determining the price of a product, an increased degree of integration is particularly advantageous.

In the case of related art two-dimensional or planar semiconductor elements, the degree of integration is mainly determined by an area occupied by unit memory cells, and is therefore greatly affected by the level of fine pattern forming technology. However, since it is advantageous to miniaturize the pattern, the degree of integration of the two-dimensional semiconductor elements is increasing, but is still limited. Accordingly, three-dimensional semiconductor memory elements including memory cells arranged in a three-dimensional manner have been proposed.

### SUMMARY

It is an aspect to provide a semiconductor memory device having improved product reliability.

According to an aspect of one or more embodiments, there is provided a semiconductor memory device comprising a cell structure; and a peripheral circuit structure on the cell structure. The cell structure includes first local bit lines which extend in a vertical direction on a first substrate, and are spaced apart in a first horizontal direction, second local bit lines which extend in the vertical direction on the first substrate, and are spaced apart from the first local bit lines in a second horizontal direction, a first global bit line which extends in the first horizontal direction, and is electrically connected to the first local bit lines, and a second global bit line which extends in the first horizontal direction, and is electrically connected to the second local bit lines. The peripheral circuit structure includes a peripheral circuit transistor on a second substrate, a first transistor which is electrically connected to the peripheral circuit transistor on the second substrate and the first global bit line, and a second transistor which is electrically connected to the peripheral circuit transistor on the second substrate and the second global bit line. The semiconductor memory device is configured to selectively turn on the first transistor and the second transistor in a complementary manner.

According to another aspect of one or more embodiments, there is provided a semiconductor memory device comprising a first cell region and a second cell region which each include a first global bit line to which first local bit lines extending in a vertical direction are connected, and a second global bit line to which second local bit lines extending in the vertical direction are connected; a sense amplifier to which the first global bit line and the second global bit line of the first cell region and the first global bit line and the second global bit line of the second cell region are commonly connected; two first transistors, a first one of the two first transistors being connected between the first global bit line of the first cell region and the sense amplifier, and a second one of the two first transistors being connected between the first global bit line of the second cell region and the sense amplifier; and two second transistors, a first one of the two second transistors being connected between the second global bit line of the first cell region and the sense amplifier, and a second one of the two second transistors being connected between the second global bit line of the second cell region and the sense amplifier. The semiconductor memory device is configured to selectively turn on the two first transistors with respect to the two second transistors in a complementary manner.

According to yet another aspect of one or more embodiments, there is provided a semiconductor memory device comprising first global bit lines and second global bit lines which extend in a first horizontal direction, the first global bit lines being arranged alternately with the second global bit lines along a second horizontal direction; first local bit lines that extend in a vertical direction, each of the first global bit lines being connected to one or more of the first local bit lines; second local bit lines that extend in the vertical direction, each of the second global bit lines being connected to one or more of the second local bit lines; first transistors, each of the first global bit lines being connected to a corresponding one of the first transistors; second transistors, each of the second global bit lines being connected to a corresponding one of the second transistors, the first transistors being arranged alternatively with the second transistors to correspond to an arrangement of the first global bit lines and the second global bit lines and to form adjacent pairs; and sense amplifiers, each adjacent pair of the first transistors and the second transistors being connected to a corresponding one of the sense amplifiers. The semiconductor memory device is configured such that when the first transistors are turned on and the second transistors are turned off, the second global bit lines are in a floating status or a pre-charged status, and when the second transistors are turned on and the second transistors are turned off, the first global bit lines are in the floating status or the pre-charged status.

At least some of the above and other features of the invention are set out in the claims.

### BRIEF DESCRIPTION OF THE DRAWINGS

The above and other aspects will be more apparent by describing in detail example embodiments thereof referring to the attached drawings, in which:
FIG. 1 is a block diagram of a semiconductor memory device according to some embodiments;
FIG. 2 is an example diagram for explaining a semiconductor memory device according to some embodiments;
FIGS. 3 and 4 are example layout diagrams of a semiconductor memory device according to some embodiments;
FIG. 5 is a cross-sectional view taken along A-A' of FIG. 4;
FIG. 6 is a cross-sectional view taken along B-B' of FIG. 4;
FIG. 7 is a cross-sectional view taken along C-C' of FIGS. 3 and 4;
FIG. 8 is an example diagram for explaining a semiconductor memory device according to some embodiments;
FIGS. 9 and 10 are cross-sectional views of a semiconductor memory device according to some embodiments;
FIGS. 11 and 12 are cross-sectional views of a semiconductor memory device according to some embodiments;
FIG. 13 is an example diagram for explaining a semiconductor memory device according to some embodiments; and
FIGS. 14 and 15 are cross-sectional views of a semiconductor memory device according to some embodiments.

### DETAILED DESCRIPTION

As used in this specification, a phrase using the form "at least one of A, B, or C" includes within its scope "only A", "only B", "only C", "A and B", "A and C", "B and C" and "A, B, and C."

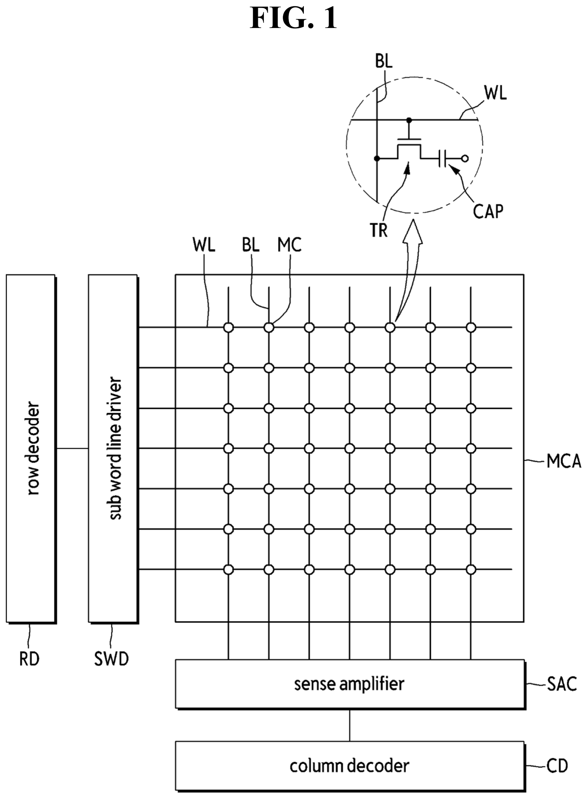

FIG. 1 is a block diagram of a semiconductor memory device according to some embodiments.

Referring to FIG. 1, the semiconductor memory device according to some embodiments may include a memory cell array MCA, a row decoder RD, a sub word line driver SWD, a sense amplifier SAC, and a column decoder CD.

The memory cell array MCA may include a plurality of memory cells MC arranged in a three-dimensional manner. The memory cells MC may be connected between word lines WL and bit lines BL that intersect each other. The memory cell MC may be, for example, a DRAM.

The memory cell MC may include a cell transistor TR and a data storage element CAP. For example, the data storage element CAP may be a capacitor. However, embodiments are not limited thereto. The cell transistor TR and the data storage element CAP may be electrically connected in series. A gate of the cell transistor TR may be connected to the word line WL, a source of the cell transistor TR may be connected to the bit line BL, and a drain of the cell transistor TR may be connected to the data storage element CAP.

The row decoder RD may decode an address that is input from the outside of the semiconductor memory device to select one of the word lines WL of the memory cell array MCA. An address decoded by the row decoder RD may be provided to the sub-word line driver SWD.

The sub-word line driver SWD may provide a voltage to each of a selected word line WL and a voltage to each of unselected word lines WL in response to the control of the control circuit. The voltages may be predetermined. In an embodiment, the voltage provided to each of the selected word lines WL may be different than the voltage provided to each of the unselected word lines WL.

The sense amplifier SAC may sense, amplify and output a voltage change of a selected bit line BL among the plurality of bit lines BL according to an address decoded from the column decoder CD. For example, the sense amplifier SAC may sense, amplify, and output a voltage difference between the selected bit line BL and a reference bit line.

The column decoder CD may provide a data transfer path between the sense amplifier SAC and an external device (e.g., a memory controller) that is external to the semiconductor memory device. The column decoder CD may decode an address that is input from the outside of the semiconductor memory device in order to select one of the bit lines BL.

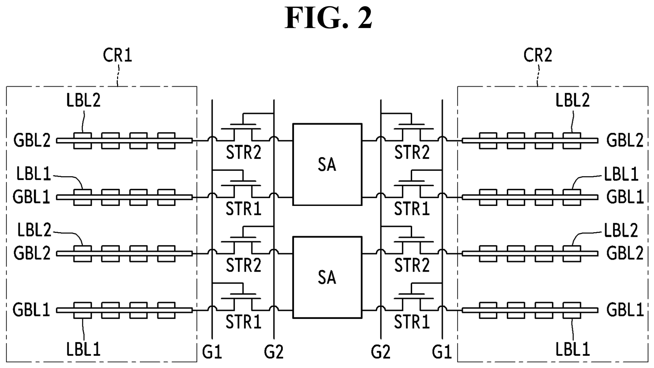

FIG. 2 is an example diagram for explaining a semiconductor memory device according to some embodiments.

Referring to FIG. 2, the semiconductor memory device according to some embodiments may include a first cell region CR1, a second cell region CR2, unit sense amplifiers SA, first transistors STR1, second transistors STR2, first gate lines G1, and second gate lines G2.

Each of the first cell region CR1 and the second cell region CR2 may include memory cells (e.g., the memory cell MC of FIG. 1) arranged in a three-dimensional manner. The first cell region CR1 and the second cell region CR2 may be spaced apart from each other in a row direction.

Each of the first cell region CR1 and the second cell region CR2 may include first local bit lines LBL1, second local bit lines LBL2, first global bit lines GBL1, and second global bit lines GBL2. The second cell region CR2 may include the same structure as the first cell region CR1. The following description focuses on the first cell region CR1 for conciseness. However, one of ordinary skill in the art will understand that the description below applies equally to the second cell region CR2.

The bit line BL of FIG. 1 may include a first local bit line LBL1 and a second local bit line LBL2. As illustrated in FIG. 2, the first local bit line LBL1 and the second local bit line LBL2 may be arranged in rows alternately along a column direction. The first local bit line LBL1 may be disposed in an odd row, and the second local bit line LBL2 may be disposed in an even row. In one row, the first local bit lines LBL1 may be spaced apart from each other in the row direction. In one row, the second local bit lines LBL2 may be spaced apart from each other in the row direction.

The first global bit line GBL1 and the second global bit line GBL2 may be disposed alternately in rows along the column direction. The first global bit line GBL1 may extend in the row direction and be connected to the first local bit lines LBL1 disposed in one row. The second global bit line GBL2 may extend in the row direction and be connected to the second local bit lines LBL2 disposed in one row. The first global bit line GBL1 may be disposed in an odd row, and the second global bit line GBL2 may be disposed in an even row.

The first global bit lines GBL1 and the second global bit lines GBL2 of the first cell region CR1 may be spaced apart from the first global bit lines GBL1 and the second global bit lines GBL2 of the second cell region CR2, as illustrated in FIG. 2. The first global bit lines GBL1 and the second global bit lines GBL2 of the first cell region CR1 may be separated from the first global bit lines GBL1 and the second global bit lines GBL2 of the second cell region CR2.

A pair of adjacent first global bit line GBL1 and second global bit line GBL2 in the first cell region CR1 may share a unit sense amplifier SA with a pair of adjacent first global bit line GBL1 and second global bit line GBL2 in the second cell region CR2. A pair of adjacent first global bit line GBL1 and second global bit line GBL2 in the first cell region CR1 and a pair of adjacent first global bit line GBL1 and second global bit line GBL2 in the second cell region CR2 may be commonly connected to one unit sense amplifier SA.

The first cell region CR1 and the second cell region CR2 may share the unit sense amplifiers SA. The pair of adjacent first global bit line GBL1 and second global bit line GBL2 of the first cell region CR1, and the pair of adjacent first global bit line GBL1 and second global bit line GBL2 of the second cell region CR2 may be commonly connected to one unit sense amplifier SA. That is, four global bit lines (first and second global bit lines GBL1 and GBL2 of the first cell region CR1 and the first and second global bit lines GBL1 and GBL2 of the second cell region CR2) may be commonly connected to one unit sense amplifier SA.

The unit sense amplifiers SA may constitute the sense amplifier SAC of FIG. 1. For example, the first global bit line GBL1 of the first cell region CR1 may be provided as a bit line of the first cell region CR1, and the second global bit line GBL2 of the second cell region CR2 may be provided as a reference bit line for the first cell region CR1.

Each of the first global bit lines GBL1 of the first and second cell regions CR1 and CR2 may be connected to a first transistor STR1 of the first transistors STR1. For example, a first transistor STR1 may be connected between a corresponding one of the first global bit lines GBL1 of the first cell region CR1 and a corresponding one of the unit sense amplifiers SA, and a first transistor STR1 may be connected between a corresponding one of the first global bit lines GBL1 of the second cell region CR2 and a corresponding one of the unit sense amplifiers SA. The first transistor STR1 may be configured to connect the first global bit line GBL1 that corresponds to the first transistor STR1 and the unit sense amplifier SA that corresponds to the first transistor. For example, the first transistor STR1 may be an nmos transistor which has a source connected to the corresponding one of the first global bit lines GBL1 and a drain connected to the corresponding one of the unit sense amplifiers SA.

Each of the second global bit lines GBL2 of the first and second cell regions CR1 and CR2 may be connected to a second transistor STR2 of the second transistors STR2. For example, a second transistor STR2 may be connected between a corresponding one of the second global bit lines GBL2 of the first cell region CR1 and a corresponding one of the unit sense amplifiers SA, and a second transistor STR2 may be connected between a corresponding one of the second global bit lines GBL2 of the second cell region CR2 and a corresponding one of the unit sense amplifiers SA. The second transistor STR2 may be configured to connect the second global bit line GBL2 that corresponds to the second transistor STR2 and the unit sense amplifier SA that corresponds to the second transistor STR2. For example, the second transistor STR2 may be an nmos transistor which has a source connected to the corresponding one of the second global bit lines GBL2 and a drain connected to the corresponding one of the unit sense amplifiers SA.

Although FIG. 2 shows that the first cell region CR1 and the second cell region CR2 each include two first global bit lines GBL1 and two second global bit lines GBL2, four first local bit lines LBL1 are connected to one first global bit line GBL1, and four second local bit lines LBL2 are connected to one second global bit line GBL2, embodiments are not limited thereto. Each of the first cell region CR1 and the second cell region CR2 may include a plurality of first global bit lines GBL1 and a plurality of the second global bit lines GBL2, and a plurality of first local bit lines LBL1 may be connected to each of the first global bit lines GBL1 and a plurality of second local bit lines LBL2 may be connected to each of the second global bit lines GBL2. That is, the number of the first global bit lines GBL1, the number of the second global bit lines GBL2, the number of the first local bit lines LBL1, and the number of the second local bit lines LBL2 may all be varied from those illustrated in FIG. 2

The gates of the first transistors STR1 connected to bit lines in the first cell region CR1 may be connected to a corresponding first gate line G1 of the first gate lines G1, and the gates of the first transistors STR1 connected to bit lines in the second cell region CR2 may be connected to a corresponding first gate line G1 of the first gate lines G1. The gates of the second transistors STR2 connected to bit lines in the first cell region CR1 may be connected to a corresponding second gate line G2 of the second gate lines G2, and the gates of the second transistors STR2 connected to bit lines in the second cell region CR2 may be connected to a corresponding second gate line G2 of the second gate lines G2. The first global bit lines GBL1 may be connected to the unit sense amplifiers SA according to a voltage applied to the first gate line G1, and the second global bit lines GBL2 may be connected to the unit sense amplifiers SA according to a voltage applied to the second gate line G2.

In some embodiments, the gates of the first transistors STR1 may be connected to different gate lines G1, and the gates of the second transistors STR2 may be connected to different gate lines G2.

The first transistors STR1 and the second transistors STR2 may be turned on or off to selectively connect the first global bit lines GBL1 and the second global bit lines GBL2 to the unit sense amplifiers SA. The first transistors STR1 and the second transistors STR2 may be selectively turned on in a complementary manner. For example, when the first global bit lines GBL1 are selected, the first transistors STR1 are turned on, the second transistors STR2 are turned off, and the first global bit lines GBL1 may be connected to the unit sense amplifiers SA. When the second global bit lines GBL2 are selected, the second transistors STR2 are turned on, the first transistors STR1 are turned off, and the second global bit lines GBL2 may be connected to the unit sense amplifiers SA.

In some embodiments, when any one of the first global bit lines GBL1 and the second global bit lines GBL2 is selected, the remaining one that is not selected may be in a floating status. For example, when the first global bit lines GBL1 are selected, the second global bit lines GBL2 may be in the floating status, and when the second global bit lines GBL2 are selected, the first global bit lines GBL1 may be in the floating status.

A coupling capacitance may exist between adjacent global bit lines GBL1 and GBL2 and between adjacent local bit lines LBL1 and LBL2. This coupling capacitance may cause a malfunction of the unit sense amplifier SA. However, in the semiconductor memory device according to some embodiments, the first global bit lines GBL1 and the second global bit lines GBL2 are selectively driven, and the unselected global bit lines may be in the floating status. That is, the unselected global bit lines may play a role in shielding the selected global bit lines from the coupling effect due to the coupling capacitance. Therefore, it is possible to provide a semiconductor memory device that may shield against and thus reduce the coupling effect of the global bit lines even without an additional conductive line.

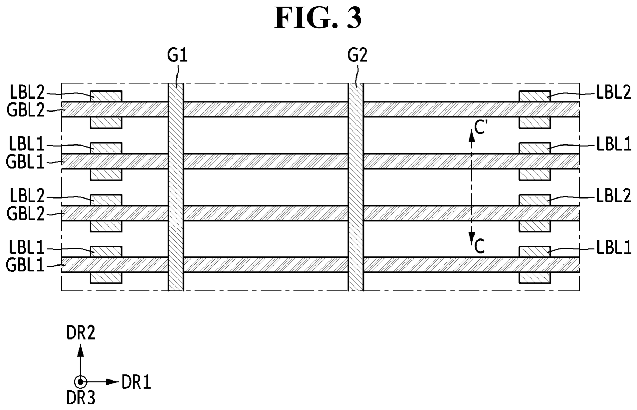

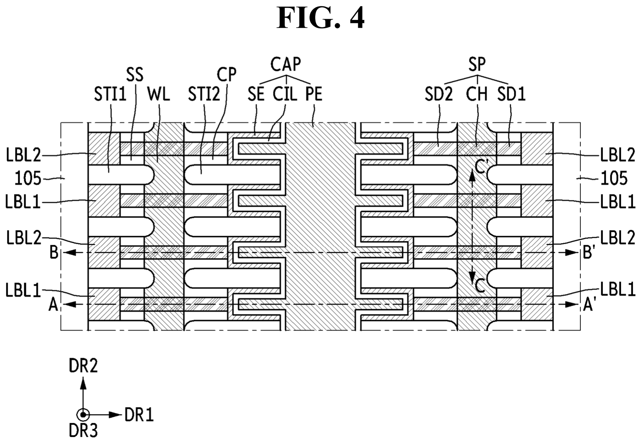

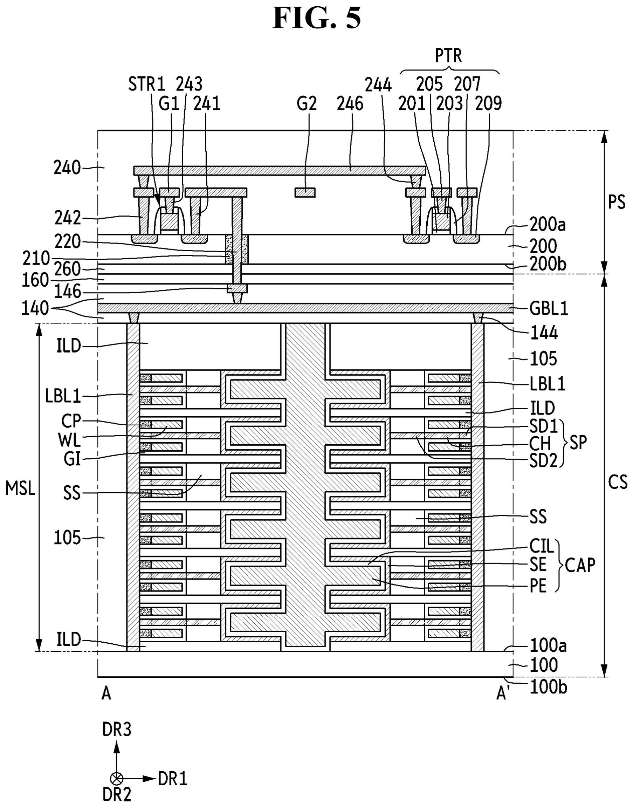

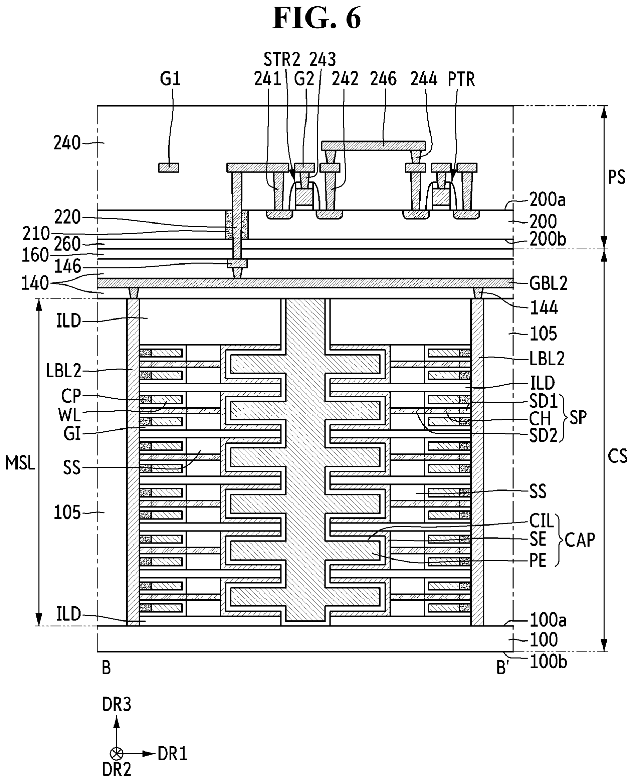

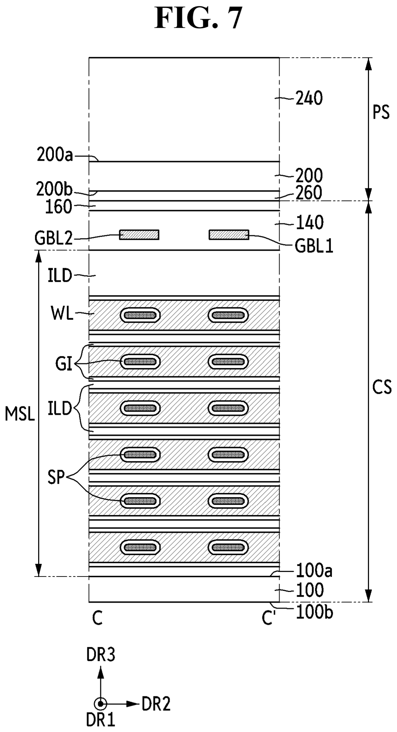

FIGS. 3 and 4 are example layout diagrams of a semiconductor memory device according to some embodiments. FIG. 5 is a cross-sectional view taken along A-A' of FIG. 4. FIG. 6 is a cross-sectional view taken along B-B' of FIG. 4. FIG. 7 is a cross-sectional view taken along C-C' of FIGS. 3 and 4. FIGS. 3 and 4 may be diagrams showing a part of the first cell region CR1 or the second cell region CR2 of FIG. 2. For convenience of explanation, repeated parts of those explained with reference to FIGS. 1 and 2 will be briefly explained or omitted for conciseness.

Referring to FIGS. 3 to 7, the semiconductor memory device according to some embodiments includes a cell structure CS and a peripheral circuit structure PS (best seen in FIGS. 5-7).

The cell structure CS includes a first substrate 100 and a memory cell layer MSL.

The first substrate 100 may include a first side 100a and a second side 100b that are opposite to each other. The first substrate 100 may be bulk silicon or silicon-on-insulator (SOI). The first substrate 100 may be a silicon substrate, or may include other materials, for example, silicon germanium, gallium arsenide, silicon germanium on insulator (SGOI), indium antimonide, lead telluride, indium arsenide, indium phosphide, gallium arsenide or gallium antimonide. In some embodiments, the first substrate 100 may have an epitaxial layer formed on a base substrate, and may be a ceramic substrate, a quartz substrate, a glass substrate for a display, or the like.

A first horizontal direction DR1, a second horizontal direction DR2, and a vertical direction DR3 may intersect each other. The first horizontal direction DR1 and the second horizontal direction DR2 may be parallel to the first side 100a of the first substrate 100. The vertical direction DR3 may be perpendicular to the first side 100a of the first substrate 100. Hereinafter, a lower portion, an upper portion, a lower side, and an upper side are defined on the basis of the vertical direction DR3. The row direction may be the first horizontal direction DR1, and the column direction may be the second horizontal direction DR2.

The memory cell layer MSL may be formed on the first side 100a of the first substrate 100. The memory cell layer MSL may include interlayer insulating patterns ILD, semiconductor patterns SP, word lines WL, a gate insulating film GI, a capping insulating pattern CP, a spacer insulating pattern SS, a first isolation insulating pattern STI1, a second isolation insulating pattern STI2, a buried insulating pattern 105, and a data storage element CAP.

The interlayer insulating patterns ILD may be stacked on the first side 100a of the first substrate 100 in a vertical direction DR3. The interlayer insulating pattern ILD may include an insulating material. The interlayer insulating pattern ILD may include at least one of, for example, a silicon oxide film, a silicon nitride film, a silicon oxynitride film, a carbon-containing silicon oxide film, a carbon-containing silicon nitride film, or a carbon-containing silicon oxynitride film. As an example, the interlayer insulating pattern ILD may include a silicon oxide film.

The semiconductor patterns SP may be stacked on the first side 100a of the first substrate 100 in the vertical direction DR3. The semiconductor patterns SP may be spaced apart in the vertical direction DR3. The semiconductor patterns SP may be disposed between the interlayer insulating patterns ILD that are adjacent to each other in the vertical direction DR3. The interlayer insulating pattern ILD may be disposed between the semiconductor patterns SP that are adjacent to each other in the vertical direction DR3.

The semiconductor patterns SP may extend long in the first horizontal direction DR1. The semiconductor patterns SP that are located at the same height may be spaced apart in the second horizontal direction DR2 (see, e.g., FIGS. 4 and 7). In a cross-sectional view such as FIG. 4, the interlayer insulating pattern ILD may protrude beyond the semiconductor pattern SP in the first horizontal direction DR1.

The semiconductor patterns SP may include at least one of a single crystal semiconductor, a polycrystalline semiconductor, an oxide semiconductor, or a two-dimensional material. For example, the single crystal semiconductor may be single crystal silicon. For example, the polycrystalline semiconductor may be polysilicon. For example, the oxide semiconductor may be selected from, but is not limited to, IGZO (InGaZnO), Sn-IGZO, IWO (InWO), IZO (InZnO), ZTO (ZnSnO), ZnO, YZO (yttrium-doped zinc oxide), IGSO (InGaSiO), InO, SnO, TiO, ZnON, MgZnO, ZrInZnO, HfInZnO, SnInZnO, AlSnInZnO, SiInZnO, AlZnSnO, GaZnSnO, and ZrZnSnO. For example, the two-dimensional semiconductor may be made of a transition metal dichalcogenide or a bipolar semiconductor material that utilizes both electrons and holes as driving charges. For example, the two-dimensional semiconductor material may be selected among, but is not limited to, MoS₂, MoSe₂, WS₂, NbS₂, TaS₂, ZrS₂, HfS₂, TcS₂, ReS₂, CuS₂, GaS₂, InS₂, SnS₂, GeS₂, PbS₂, WSe₂, NbSe₂, TaSe₂, ZrSe₂, HfSe₂, TcSe₂, ReSe₂, CuSe₂, GaSe₂, InSe₂, SnSe₂, GeSe₂, PbSe₂, MoTe₂, WTe₂, NbTe₂, TaTe₂, ZrTe₂, HfTe₂, TcTe₂, ReTe₂, CuTe₂, GaTe₂, InTe₂, SnTe₂, GeTe₂, and PbTe₂.

The semiconductor pattern SP may include a channel region CH, a first impurity region SD1, and a second impurity region SD2. The channel region CH may be interposed between the first and second impurity regions SD1 and SD2. The first impurity region SD1 may be connected to the bit line BL. The second impurity region SD2 may be connected to the data storage element CAP. The second impurity region SD2 may be connected to the storage electrode SE.

The channel region CH may correspond to the channel of the cell transistor TR described with reference to FIG. 1. Each of the first and second impurity regions SD1 and SD2 may correspond to the source and drain of the cell transistor TR described with reference to FIG. 1.

The first and second impurity regions SD1 and SD2 may be regions in which impurities are doped in the semiconductor pattern SP. The first and second impurity regions SD1 and SD2 may have n-type or p-type conductivity. The first impurity region SD1 may be formed at a first end of the semiconductor pattern SP, and the second impurity region SD2 may be formed at a second end of the semiconductor pattern SP. The second end may be opposite to the first end in the first horizontal direction DR1.

The second local bit line LBL2 may be spaced apart from the first local bit line LBL1 in the second horizontal direction DR2 (see, e.g., FIG. 4). The first local bit line LBL1 and the second local bit line LBL2 may be disposed alternately along the second horizontal direction DR2.

A plurality of memory cells (e.g., the memory cells MC of FIG. 1) that are spaced apart in the vertical direction DR3 may be connected to each of the first local bit line LBL1 and the second local bit line LBL2. The first local bit line LBL1 and the second local bit line LBL2 may be directly connected to the memory cells (e.g., the memory cells MC of FIG. 1).

The first and second local bit lines LBL1 and LBL2 may be disposed against the semiconductor patterns SP and the interlayer insulating patterns ILD in the first horizontal direction DR1, as illustrated in FIGS. 5-6. Each of the first and second local bit lines LBL1 and LBL2 may extend long in the vertical direction DR3 on the first side 100a of the first substrate 100. Each of the first and second local bit lines LBL1 and LBL2 may be connected to the semiconductor patterns SP that are spaced apart in the vertical direction DR3. Each of the first and second local bit lines LBL1 and LBL2 may be connected to the semiconductor patterns SP that are spaced apart in the vertical direction DR3.

Each of the first and second local bit lines (LBL1 and LBL2) may include a conductive material. For example, each of the first and second local bit lines (LBL1 and LBL2) may include, but is not limited to, at least one of a doped semiconductor material (doped silicon, doped silicon-germanium, doped germanium, etc.), a conductive metal nitride (titanium nitride, tantalum nitride, etc.), a metal (tungsten, titanium, tantalum, etc.), or a metal-semiconductor compound (tungsten silicide, cobalt silicide, titanium silicide, etc.).

The word lines WL may extend along the second horizontal direction DR2 on the first side 100a of the first substrate 100, as illustrated, for example, in FIGS. 4 and 7. The word lines WL may be spaced apart in the vertical direction DR3. The word line WL may be disposed on at least a part of the outer peripheral side of the channel region CH of the semiconductor pattern SP. The word line WL may extend along the second horizontal direction DR2. The word line WL may intersect the semiconductor patterns SP spaced apart in the second horizontal direction DR2 at the same height.

In some embodiments, the cell transistor TR of FIG. 1 may be a gate-all-around transistor. The word line WL may surround the channel region CH. The word line WL may cover the outer peripheral side of the channel region CH. The word line WL may extend in the second horizontal direction DR2 and surround the channel region CH of each semiconductor pattern SP that is disposed to be spaced apart in the second horizontal direction DR2 at the same height.

Unlike the shown example in FIGS. 1-7, in some embodiments, the cell transistor TR of FIG. 1 may have a double-gate transistor structure. The word lines WL may be disposed and spaced apart on opposite both side walls (e.g., side walls opposite to each other in the vertical direction DR3) of the channel region CH. In some embodiments, the word line WL may be disposed on one side wall of the channel region CH.

The word line WL may include a conductive material. For example, the word line WL may include, but is not limited to, at least one of a doped semiconductor material, a conductive metal nitride, a metal, or a metal-semiconductor compound.

The gate insulating film GI may be disposed between the word line WL and the semiconductor pattern SP, and between the word line WL and the interlayer insulating pattern ILD. The gate insulating film GI may extend along the upper and lower sides of the word line WL and one side wall extending in the vertical direction DR3 and adjacent to the spacer insulating pattern SS.

The gate insulating film GI may include, for example, at least one of a high dielectric constant insulating film having a dielectric constant higher than silicon oxide, a silicon oxide film, a silicon nitride film, or a silicon oxynitride film.

The capping insulating pattern CP may be disposed between the first impurity region SD1 of the semiconductor pattern SP and the interlayer insulating pattern ILD in the vertical direction DR3. The capping insulating pattern CP may be disposed on the upper and lower sides of the semiconductor pattern SP. The capping insulating pattern CP may spatially separate the bit line BL and the word line WL. The gate insulating film GI may be interposed between the capping insulating pattern CP and the interlayer insulating pattern ILD, and between the capping insulating pattern CP and the semiconductor pattern SP.

The spacer insulating pattern SS may be disposed between the second impurity region SD2 of the semiconductor pattern SP and the interlayer insulating pattern ILD. The spacer insulating pattern SS may be disposed on the upper side and the lower side of the semiconductor pattern SP. The spacer insulating pattern SS may be spaced apart from the word line WL with a gate insulating film GI interposed therebetween. The gate insulating film GI may be interposed between the spacer insulating pattern SS and the interlayer insulating pattern ILD, and between the spacer insulating pattern SS and the semiconductor pattern SP.

Each of the capping insulating pattern CP and the spacer insulating pattern SS may include at least one of, for example, a silicon oxide film, a silicon nitride film, a silicon oxynitride film, a carbon-containing silicon oxide film, a carbon-containing silicon nitride film, or a carbon-containing silicon oxynitride film.

The first and second isolation insulating patterns STI1 and STI2 may be disposed on the first side 100a of the first substrate 100. The first isolation insulating pattern STI1 may be disposed between the bit lines BL that are adjacent to each other in the second horizontal direction DR2, as illustrated, for example, in FIG. 4. A second isolation insulating pattern STI2 may be disposed between the storage electrodes SE that are adjacent to each other in the second horizontal direction DR2.

The buried insulating pattern 105 may be disposed on the first side 100a of the first substrate 100. The buried insulating pattern 105 may cover the side wall of the bit line BL (e.g., the first and second local bit lines LBL1 and LBL2) and the side wall of the first isolation insulating pattern STI1.

The first and second isolation insulating patterns STI1 and STI2 and the buried insulating pattern 105 may each be formed of at least one of an insulating material formed using a SOG technique, for example, silicon oxide, or silicon oxynitride.

The data storage element CAP may be disposed on the first side 100a of the first substrate 100. The data storage element CAP may be disposed against a plurality of semiconductor patterns SP and the interlayer insulating pattern ILD in the first horizontal direction DR1. The data storage element CAP may include a capacitor dielectric film CIL, a plurality of storage electrodes SE, and a plate electrode PE. Each data storage element CAP may include a storage electrode SE, a capacitor dielectric film CIL, and a plate electrode PE that are disposed between the interlayer insulating patterns ILD. Each data storage element CAP may be defined by a corresponding one of the storage electrodes SE.

The capacitor dielectric film CIL may be disposed on the storage electrode SE and the interlayer insulating pattern ILD. The capacitor dielectric film CIL may extend along the profiles of the plurality of storage electrodes SE and the side faces of the plurality of interlayer insulating patterns ILD. The plate electrode PE may be disposed on the capacitor dielectric film CIL. The capacitor dielectric film CIL and the plate electrode PE may be sequentially disposed on the storage electrode SE.

The capacitor dielectric film CIL and the plate electrode PE that are included in each data storage element CAP may be connected to each other.

Each of the storage electrode SE and the plate electrode PE may include, but is not limited to, a doped semiconductor material, a conductive metal nitride (e.g., titanium nitride, tantalum nitride, niobium nitride or tungsten nitride), a metal (e.g., ruthenium, iridium, titanium, niobium, tungsten, cobalt, molybdenum or tantalum), and/or a conductive metal oxide (e.g., iridium oxide or niobium oxide). As an example, the storage electrode SE may include a conductive metal nitride, a metal, and/or a conductive metal oxide. The conductive metal nitride, the metal, and/or the conductive metal oxide may be included in a metallic conductive film.

The capacitor dielectric film CIL may include, for example, a high dielectric constant material (e.g., hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, lead zinc niobate or combinations thereof). In the semiconductor memory device according to some embodiments, the capacitor dielectric film CIL may include a stacked film structure in which zirconium oxide, aluminum oxide, and zirconium oxide are stacked in sequence. In the semiconductor memory device according to some embodiments, the capacitor dielectric film CIL may include hafnium (Hf).

A first insulating layer 140 may be disposed on the memory cell layer MSL. The first insulating layer 140 may include an insulating material and may be made up of the plurality of layers.

The first and second global bit lines GBL1 and GBL2 may be disposed inside the first insulating layer 140. The second global bit line GBL2 may be spaced apart from the first global bit line GBL1 in the second horizontal direction DR2 (see, e.g., FIG. 7). The second global bit line GBL2 and the first global bit line GBL1 may be disposed alternately along the second horizontal direction DR2. Each of the first and second global bit lines GBL1 and GBL2 may extend long in the first horizontal direction DR1.

The first global bit line GBL1 may be disposed on the first local bit lines LBL1 that are spaced apart along the first horizontal direction DR1. The first global bit line GBL1 may be electrically connected to the first local bit lines LBL1 that are spaced apart along the first horizontal direction DR1. The second global bit line GBL2 may be disposed on the second local bit lines LBL2 that are spaced apart along the first horizontal direction DR1. The second global bit line GBL2 may be electrically connected to the second local bit lines LBL2 that are spaced apart along the first horizontal direction DR1.

Each of the first and second global bit lines GBL1 and GBL2 may include a conductive material. For example, each of the first and second global bit lines GBL1 and GBL2 may include, for example, but is not limited to, at least one of a doped a semiconductor material (doped silicon, doped silicon-germanium, doped germanium, etc.), a conductive metal nitride (titanium nitride, tantalum nitride, etc.), a metal (tungsten, titanium, tantalum, etc.), or a metal-semiconductor combination (tungsten silicide, cobalt silicide, titanium silicide, etc.).

Vias 144 and wiring 146 may be disposed inside the first insulating layer 140. The first and second global bit lines GBL1 and GBL2 may be disposed at a particular metal level in the first insulating layer 140. The placement, number, and connection relationship of the vias 144, the wiring 146, the first global bit line GBL1, and the second global bit line GBL2 may be changed variously. Each of the vias 144 and the wirings 146 may include a conductive material.

The vias 144 may be disposed between the first global bit line GBL1 and the first local bit line LBL1, between the second global bit line GBL2 and the second local bit line LBL2, between the first global bit line GBL1 and the wiring 146, and between the second global bit line GBL2 and the wiring 146. The first global bit line GBL1 may be electrically connected to the first local bit line LBL1 through the vias 144. The second global bit line GBL2 may be electrically connected to the second local bit line LBL2 through the vias 144.

A first bonding insulating layer 160 may be disposed on the first insulating layer 140. The first bonding insulating layer 160 may be located at the uppermost layer of the cell structure CS.

The peripheral circuit structure PS may be disposed on the cell structure CS. The peripheral circuit structure PS may include a second substrate 200, a first transistor STR1, a second transistor STR2, a peripheral circuit transistor PTR, a second insulating layer 240, a first source/drain contact 241, a second source/drain contact 242, a gate contact 243, a first gate line G1, a second gate line G2, a via 244, a wiring 246, an insulating pattern 210, a through via 220, and a second bonding insulating layer 260. The first transistor STR1, the second transistor STR2, the first gate line G1, and the second gate line G2 may correspond to the first transistor STR1, the second transistor STR2, the first gate line G1, and the second gate line G2 described above with reference to FIG. 2.

The second substrate 200 may include a third side 200a and a fourth side 200b that are opposite to each other. The fourth side 200b of the second substrate 200 may be opposite to the first side 100a of the first substrate 100.

The second substrate 200 may be bulk silicon or silicon-on-insulator (SOI). The second substrate 200 may be a silicon substrate, or may include other materials, for example, silicon germanium, gallium arsenide, silicon germanium on insulator (SGOI), indium antimonide, lead telluride, indium arsenide, indium phosphide, gallium arsenide or gallium antimonide. In some embodiments, the second substrate 200 may have an epitaxial layer formed on a base substrate, and may be a ceramic substrate, a quartz substrate, a display glass substrate, or the like.

The first transistor STR1, the second transistor STR2, and the peripheral circuit transistor PTR may be disposed on the third side 200a of the second substrate 200.

Each of the first transistor STR1, the second transistor STR2, and the peripheral circuit transistor PTR may include a gate insulating pattern 201, a gate electrode 203, a gate capping pattern 205, a gate spacer 207, and first and second source/drain regions 209. The gate insulating pattern 201 may be disposed between the gate electrode 203 and the second substrate 200. The gate capping pattern 205 may be disposed on the gate electrode 203. The gate spacer 207 may cover the side walls of the gate insulating pattern 201, the gate electrode 203, and the gate capping pattern 205. The first and second source/drain regions 209 may be provided inside the second substrate 200 adjacent to both sides of the gate electrode 203.

The peripheral circuit transistor PTR may constitute the unit sense amplifier SA of FIG. 2.

The second insulating layer 240 may be disposed on the third side 200a of the second substrate 200. The second insulating layer 240 may include an insulating material, and may be made up of the plurality of layers.

The first source/drain contact 241, the second source/drain contact 242, the gate contact 243, the first gate line G1, the second gate line G2, the via 244, and the wiring 246 may be disposed inside the second insulating layer 240. The first source/drain contact 241, the second source/drain contact 242, the gate contact 243, the first gate line G1, the second gate line G2, the via 244, and the wiring 246 may each include a conductive material.

A gate contact 243 may be disposed on the gate electrode 203 of each of the first transistor STR1, the second transistor STR2, and the peripheral circuit transistor PTR. The gate contact 243 may be in contact with the gate electrode 203 of each of the first transistor STR1, the second transistor STR2, and the peripheral circuit transistor PTR.

The first and second source/drain contacts 241 and 242 may be disposed on the first and second source/drain regions 209 of the first transistor STR1, the second transistor STR2, and the peripheral circuit transistor PTR. The first source/drain contact 241 may be in contact with the first source/drain region 209 of the first transistor STR1, the second transistor STR2, and the peripheral circuit transistor PTR. The first source/drain region 209 that is in contact with the first source/drain contact 241 may correspond to the source of the first transistor STR1, the second transistor STR2, and the peripheral circuit transistor PTR. The second source/drain contact 242 may be in contact with the second source/drain region 209 of the first transistor STR1, the second transistor STR2, and the peripheral circuit transistor PTR. The second source/drain region 209 that is in contact with the second source/drain contact 242 may correspond to the drain of the first transistor STR1, the second transistor STR2, and the peripheral circuit transistor PTR.

The cell structure CS and the peripheral circuit structure PS may be electrically connected to each other through the through via 220. The through via 220 penetrates the second substrate 200, and may be electrically connected to each of the first global bit line GBL1 and the second global bit line GBL2. The through via 220 may be disposed in the second insulating layer 240, the second substrate 200, the second bonding insulating layer 260, and the first bonding insulating layer 160. For example, the through via 220 may be in contact with the wiring 146 disposed on the uppermost layer inside the first insulating layer 140. The through via 220 may be electrically connected to each of the first and second global bit lines GBL1 and GBL2 through the wiring 146 and the via 144. The through via 220 may include a conductive material.

The insulating pattern 210 may be disposed between the second substrate 200 and the through via 220.

The through via 220 may be electrically connected to the wirings 246 and the vias 244. The wirings 246 and the vias 244 may be electrically connected to the first transistor STR1, the second transistor STR2, and the peripheral circuit transistor PTR. Each of the first gate line G1 and the second gate line G2 may be any one of the wirings 246. The placement, number, and connection relationship of the wirings 246 and the vias 244, and the placement, number, and connection relationship of the first gate line G1 and the second gate line G2 may be variously changed.

The first gate line G1 may extend along the second horizontal direction DR2. The first gate line G1 may be electrically connected to the gate electrode 203 of the first transistor STR1. The first gate line G1 may be connected to the gate electrode 203 of the first transistors STR1 through the gate contact 243. The second gate line G2 may extend along the second horizontal direction DR2. The second gate line G2 may be electrically connected to the gate electrode 203 of the second transistor STR2. The second gate line G2 may be connected to the gate electrode 203 of the second transistors STR2 through the gate contact 243.

The first source/drain region 209 of the first transistors STR1 may be electrically connected to the first global bit line GBL1 through the first source/drain contact 241, the wiring 246 and/or the via 244, and the through via 220. The second source/drain region 209 of the first transistors STR1 may be electrically connected to the peripheral circuit transistor PTR through the second source/drain contact 242, the wiring 246, and/or the via 244.

The first source/drain region 209 of the second transistors STR2 may be electrically connected to the second global bit line GBL2 through the first source/drain contact 241, the wiring 246 and/or the via 244, and the through via 220. The second source/drain region 209 of the second transistors STR2 may be electrically connected to the peripheral circuit transistor PTR through the second source/drain contact 242, the wiring 246, and/or the via 244.

The second bonding insulating layer 260 may be disposed on the fourth side 200b of the second substrate 200. The first bonding insulating layer 160 may be in contact with the second bonding insulating layer 260. The first bonding insulating layer 160 and the second bonding insulating layer 260 may be bonded to each other. Each of the first bonding insulating layer 160 and the second bonding insulating layer 260 may include an insulating material such as silicon oxide.

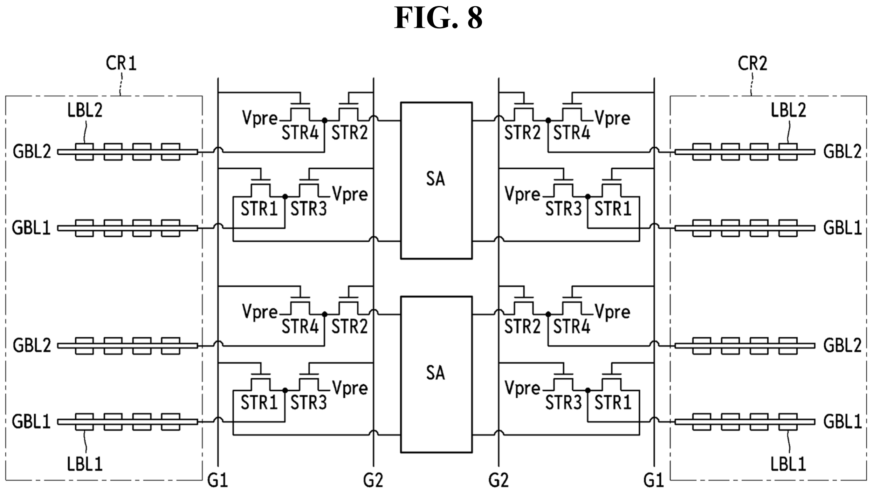

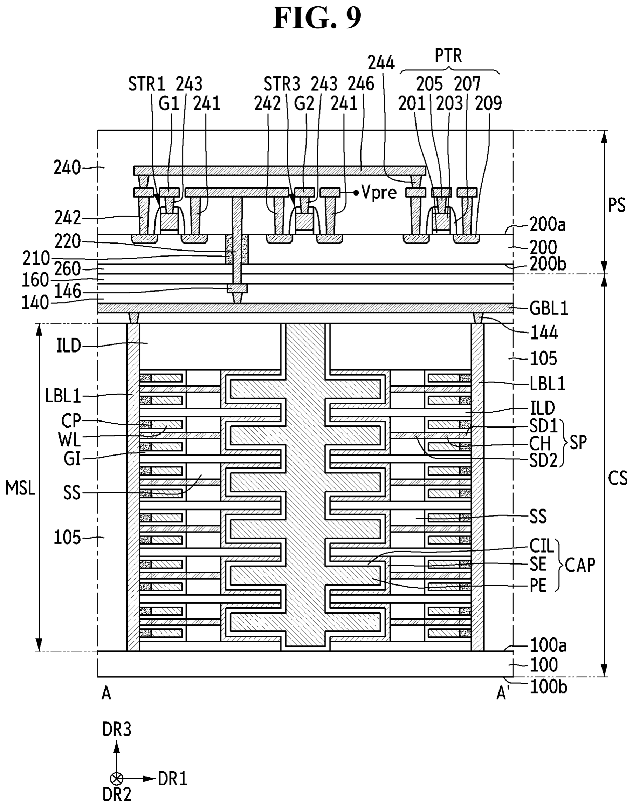

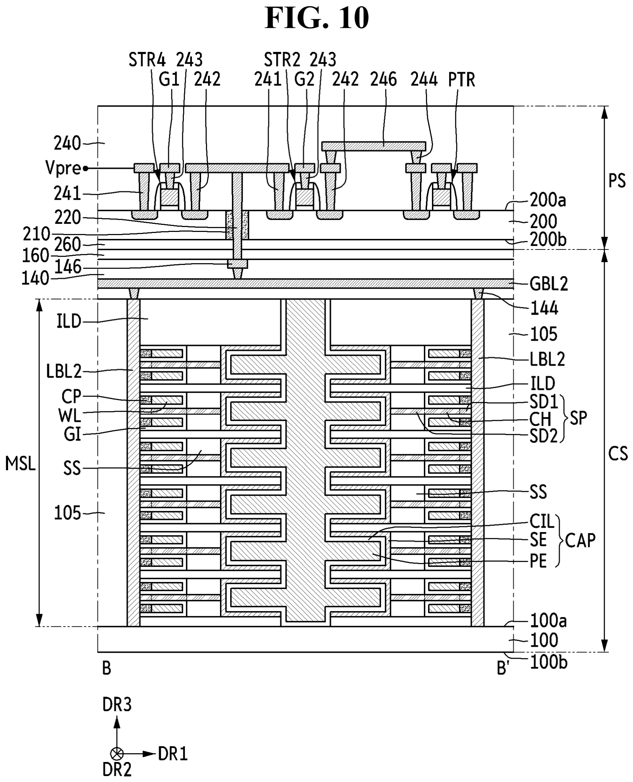

FIG. 8 is an example diagram for explaining a semiconductor memory device according to some embodiments. FIGS. 9 and 10 are cross-sectional views of the semiconductor memory device according to some embodiments. For convenience of explanation, repeated parts of those described above with reference to FIGS. 1 to 7 will be briefly explained or omitted for conciseness.

Referring to FIG. 8, in the semiconductor memory device according to some embodiments, when any one of the first global bit lines GBL1 and the second global bit lines GBL2 is selected, the remaining one that is not selected may be in a pre-charged status. For example, when the first global bit lines GBL1 are selected, the second global bit lines GBL2 may be in the pre-charged status, and when the second global bit lines GBL2 are selected, the first global bit line GBL1 may be in the pre-charged status.

The semiconductor memory device according to some embodiments may further include third transistors STR3 and fourth transistors STR4.

The third transistor STR3 may be physically disposed between the first transistor STR1 of the first cell region CR1 and the unit sense amplifier SA in the first horizontal direction DR1, as illustrated in FIG. 9, and between the first transistor STR1 of the second cell region CR2 and the unit sense amplifier SA, respectively. The third transistor STR3 may be configured to provide a pre-charge voltage Vpre to the first global bit line GBL1. For example, the third transistor STR3 may be an nmos transistor in which a drain thereof is connected to the first global bit line GBL1 and the pre-charge voltage Vpre is connected to a source thereof.

The fourth transistor STR4 may be physically disposed such that the second transistor STR2 of the first cell region CR1 is between the fourth transistor STR4 and the unit sense amplifier SA, respectively. The fourth transistor STR4 may be configured to provide the pre-charge voltage Vpre to the second global bit line GBL2. For example, the fourth transistor STR4 may be a nmos transistor in which a drain thereof is connected to the second global bit line GBL2 and the pre-charge voltage Vpre is connected to a source thereof.

The gates of the first transistors STR1 and the gates of the fourth transistors STR4 connected to the first cell region CR1, and the gates of the first transistor STR1 and the gates of the fourth transistors STR4 connected to the second cell region CR2 may be connected to a first gate line G1, respectively. The gates of the second transistor STR2 and the gates of the third transistor STR3 connected to the first cell region CR1, and the gates of the second transistors STR2 and the gates of the third transistors STR3 connected to the second cell region CR2 may be connected to a second gate line G2, respectively.

The first transistors STR1 and the fourth transistors STR4 may be turned on together and the second transistors STR2 and the third transistors STR3 may be turned on together. The first transistors STR1 and the fourth transistors STR4 may be turned on together in a complementary manner with the second transistors STR2 and the third transistors STR3 that are turned on together. For example, when the first global bit lines GBL1 are selected, the first transistors STR1 and the fourth transistors STR4 are turned on, the second transistors STR2 and the third transistors STR3 are turned off, the first global bit lines GBL1 may be connected to the unit sense amplifier SA, and the pre-charge voltage Vpre may be provided to the second global bit lines GBL2. When the second global bit lines GBL2 are selected, the second transistors STR2 and the third transistors STR3 are turned on, the first transistors STR1 and the fourth transistors STR4 are turned off, the second global bit lines GBL2 may be connected to the unit sense amplifiers SA, and the pre-charge voltage Vpre may be provided to the first global bit lines GBL1.

In some embodiments, when either the first global bit lines GBL1 or the second global bit lines GBL2 is selected, the remaining one that is not selected may be in the pre-charged status. For example, when the first global bit lines GBL1 are selected, the second global bit lines GBL2 may be in the pre-charged status, and when the second global bit lines GBL2 are selected, the first global bit lines GBL1 may be in the pre-charged status. In other words, the unselected global bit lines may serve to shield the selected global bit lines from the coupling effect due to the coupling capacitance. Therefore, it is possible to provide a semiconductor memory device that may shield the coupling effect of the global bit lines even without additional conductive lines.

Referring to FIGS. 8 to 10, in the semiconductor memory device according to some embodiments, the peripheral circuit structure PS may further include the third transistor STR3 and the fourth transistor STR4.

The third transistor STR3 and the fourth transistor STR4 may be disposed on the third side 200a of the second substrate 200. Each of the third transistor STR3 and the fourth transistor STR4 may include a gate insulating pattern 201, a gate electrode 203, a gate capping pattern 205, a gate spacer 207, and first and second source/drain regions 209.

A gate contact 243 may be further disposed on the gate electrode 203 of each of the third and fourth transistors STR3 and STR4. The gate contact 243 may be in contact with the gate electrode 203 of each of the third and fourth transistors STR3 and STR4.

The first and second source/drain contacts 241 and 242 may be further disposed on the first and second source/drain regions 209 of the respective third and fourth transistors STR3 and STR4. The first source/drain contact 241 may be in contact with the first source/drain region 209 of the third and fourth transistors STR3 and STR4. The first source/drain region 209 that is in contact with the first source/drain contact 241 may correspond to the source of the third and fourth transistors STR3 and STR4. The second source/drain contact 242 may be in contact with the second source/drain region 209 of the third and fourth transistors STR3 and STR4. The second source/drain region 209 that is in contact with the second source/drain contact 242 may correspond to the drain of the third and fourth transistors STR3 and STR4.

The first gate line G1 may be electrically connected to the gate electrode 203 of the first transistors STR1 and the gate electrode 203 of the fourth transistor STR4. The first gate line G1 may be connected to the gate electrodes 203 of the first and fourth transistors STR1 and STR4 through the gate contact 243. The second gate line G2 may be electrically connected to the gate electrode 203 of the second transistors STR2 and the gate electrode 203 of the third transistors STR3. The second gate line G2 may be connected to the gate electrodes 203 of the second and third transistors STR2 and STR3 through the gate contact 243.

The first source/drain region 209 of the first transistors STR1 and the second source/drain regions 209 of the third transistor STR3 may be electrically connected to the first global bit line GBL1 through the first and second source/drain contacts 241 and 242, the wiring 246 and/or the via 244, and the through via 220. The first source/drain region 209 of the third transistors STR4 may be electrically connected to a wiring to which the pre-charge voltage Vpre is provided.

The first source/drain region 209 of the second transistors STR2 and the second source/drain region 209 of the fourth transistors STR4 may be electrically connected to the second global bit line GBL2 through the first and second source/drain contacts 241 and 242, the wiring 246 and/or the via 244 and the through via 220. The first source/drain region 209 of the fourth transistors STR4 may be electrically connected to a wiring to which the pre-charge voltage Vpre is provided.

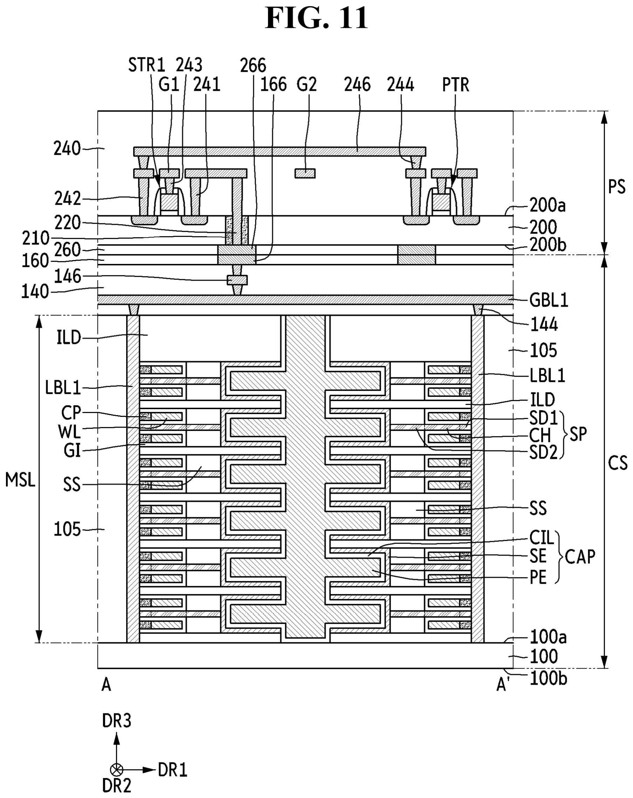

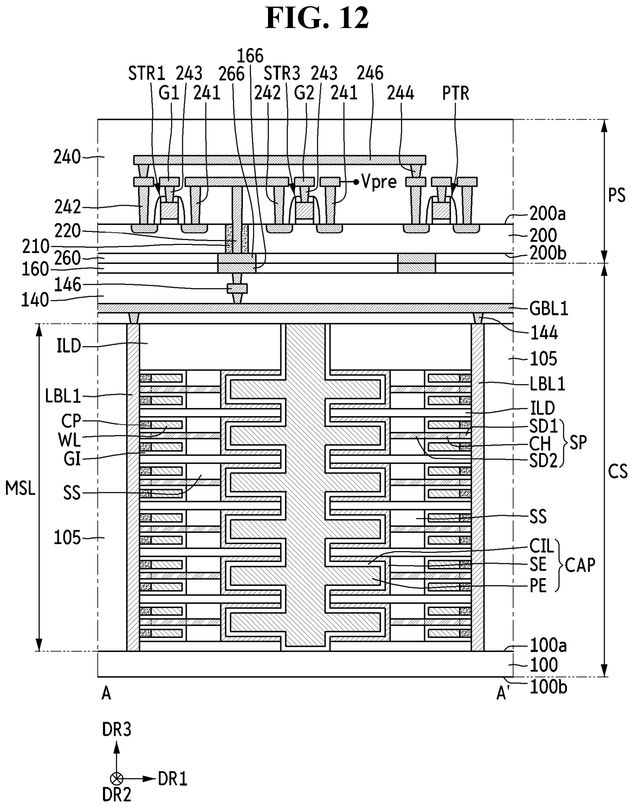

FIGS. 11 and 12 are cross-sectional views of a semiconductor memory device according to some embodiments. For convenience of explanation, repeated parts of those described above using FIGS. 1 to 10 will be briefly explained or omitted for conciseness.

Referring to FIG. 12, the semiconductor memory device according to some embodiments may have a chip-to-chip (C2C) structure bonded in a wafer bonding manner. After fabricating the cell structure CS and the peripheral circuit structure PS, the cell structure CS and the peripheral circuit structure PS may be bonded to fabricate a semiconductor memory device.

The cell structure CS may further include a first bonding pad 166 inside the first bonding insulating layer 160. The first bonding pad 166 may be electrically connected to the via 144. The first bonding pad 166 may be disposed on an uppermost metal layer of the cell structure CS on the basis of the first side 100a of the first substrate 100. Although the via 144 and the wiring 146 are shown as being disposed between the first bonding pad 166 and the first global bit line GBL1, embodiments are not limited thereto, and in some embodiments, only the via 144 may be disposed between the first bonding pad 166 and the first global bit line GBL1.

The peripheral circuit structure PS may further include a second bonding pad 266 inside the second bonding insulating layer 260. The second bonding pad 266 may be electrically connected to the through via 220. The second bonding pad 266 may be disposed on the uppermost metal layer of the peripheral circuit structure PS on the basis of the fourth side 200b of the second substrate 200. Although the second bonding pad 266 and the through via 220 are shown to be in contact with each other, embodiments are not limited thereto, and in some embodiments, an insulating layer and wiring and/or vias inside the insulating layer may be further disposed between the second substrate 200 and the second bonding insulating layer 260.

The first bonding pad 166 of the cell structure CS and the second bonding pad 266 of the peripheral circuit structure PS may be bonded to each other. The first bonding pad 166 and the second bonding pad 266 may be in contact with each other.

Referring to FIG. 11, the first source/drain region 209 of the first transistors STR1 may be electrically connected to the first global bit line GBL1 through the first source/drain contact 241, the wiring 246 and/or the via 244, the through via 220, the second bonding pad 266, the first bonding pad 166, and the via 144.

Referring to FIG. 12, the first source/drain region 209 of the first transistors STR1 and the second source/drain region 209 of the third transistors STR3 may be electrically connected to the first global bit line GBL1 through the first and second source/drain contacts 241 and 242, the wiring 246 and/or the via 244, the through via 220, the second bonding pad 266, the first bonding pad 166, and the via 144.

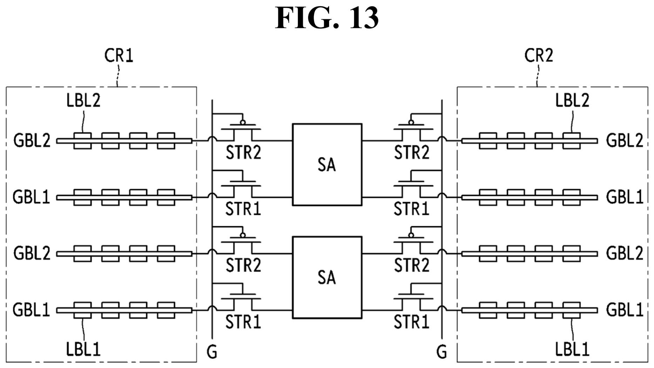

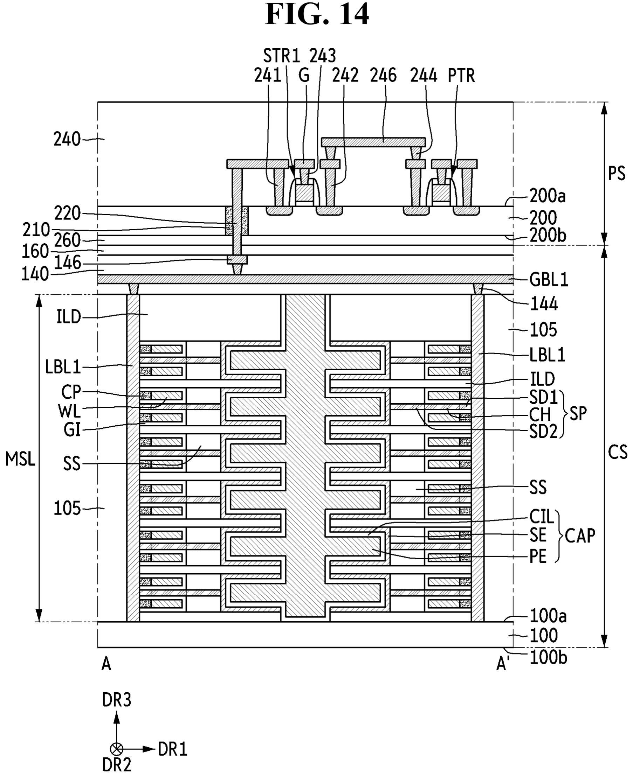

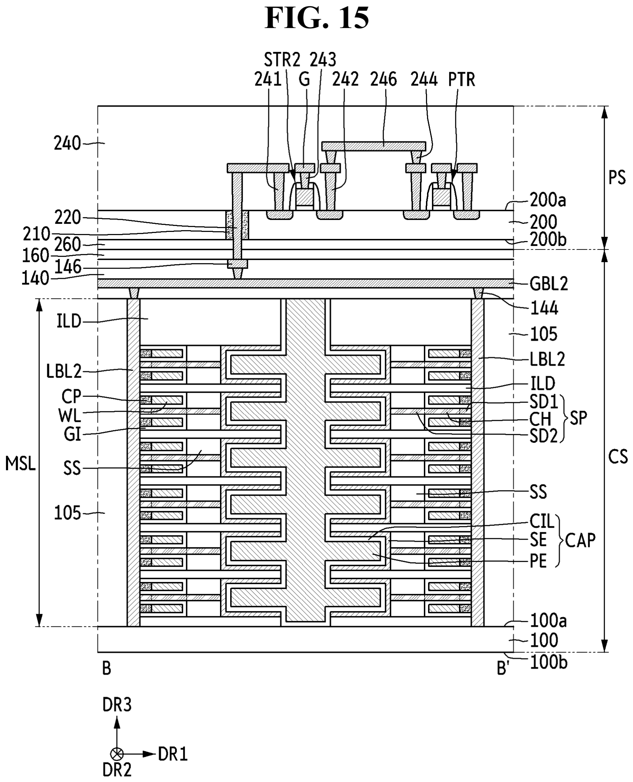

FIG. 13 is an example view for explaining a semiconductor memory device according to some embodiments. FIGS. 14 and 15 are cross-sectional views of the semiconductor memory device according to some embodiments. For convenience of explanation, repeated parts of those described above using FIGS. 1 to 7 will be briefly explained or omitted for conciseness.

Referring to FIG. 13, in the semiconductor memory device according to some embodiments, the gate of the first transistors STR1 and the gate of the second transistors STR2 may be connected to a same gate line G. The first transistors STR1 and the second transistors STR2 may be transistors of different conductivity types from each other.

For example, the first transistor STR1 may be an nmos transistor in which a source thereof is connected to the first global bit line GBL1 and a drain is connected to the unit sense amplifier SA, and the second transistor STR2 may be a pmos transistor in which a drain thereof is connected to the second global bit line GBL2 and a source is connected to the unit sense amplifier SA.

The gate of the first transistors STR1 connected to the first cell region CR1 and the gate of the second transistors STR2 connected to the first cell region CR1 may be connected to the gate line G. The gate of the first transistors STR1 connected to the second cell region CR2 and the gate of the second transistors STR2 connected to the second cell region CR2 may be connected to the gate line G.

Referring to FIGS. 13 to 15, in the semiconductor memory device according to some embodiments, the peripheral circuit structure PS may include a gate line G.

The gate line G may be disposed inside the second insulating layer 240. The gate line G may be any one of the wirings 246. The placement, number, and connection relationship of the gate lines G may be variously changed.

The gate line G may extend along the second horizontal direction DR2. The gate line G may be electrically connected to the gate electrode 203 of the first transistors STR1 and the gate electrode 203 of the second transistors STR2. The gate line G may be connected to the gate electrode 203 of the first transistors STR1 and the gate electrode 203 of the second transistors STR2 through the gate contact 243.

The second source/drain region 209 of the second transistors STR2 may be electrically connected to the second global bit line GBL2 through the second source/drain contact 242, the wiring 246 and/or the via 244, and the through via 220. The first source/drain region 209 of the second transistors STR2 may be electrically connected to the peripheral circuit transistor PTR through the first source/drain contact 241, the wiring 246, and/or the via 244.

Although various embodiments have been described above with reference to the accompanying drawings, the present disclosure is not limited to the above embodiments, and embodiments may be provided in various different forms. Those skilled in the art will appreciate that the present disclosure may be embodied in other specific forms without changing the technical scope or essential features of the present disclosure. Accordingly, the above-described embodiments should be understood in all respects as illustrative and not restrictive and the above-described embodiments and various modifications thereto should be understand as being included in the scope of the accompanying claims.

Embodiments are set out in the following clauses:
Clause 1. A semiconductor memory device comprising:
   a first cell region and a second cell region which each include a first global bit line to which first local bit lines extending in a vertical direction are connected, and a second global bit line to which second local bit lines extending in the vertical direction are connected;
   a sense amplifier to which the first global bit line and the second global bit line of the first cell region and the first global bit line and the second global bit line of the second cell region are commonly connected;
   two first transistors, a first one of the two first transistors being connected between the first global bit line of the first cell region and the sense amplifier, and a second one of the two first transistors being connected between the first global bit line of the second cell region and the sense amplifier; and
   two second transistors, a first one of the two second transistors being connected between the second global bit line of the first cell region and the sense amplifier, and a second one of the two second transistors being connected between the second global bit line of the second cell region and the sense amplifier,
   wherein wherein the semiconductor memory device is configured to selectively turn in the two first transistors with respect to the two second transistors in a complementary manner.
Clause 2. The semiconductor memory device of clause 1,
   wherein gates of the two first transistors are connected to first gate lines, respectively, and
   gates of the two second transistors are connected to second gate lines, respectively, that are different from the first gate lines.
Clause 3. The semiconductor memory device of clause 1,
   wherein the gates of the two first transistors and the gates of the two second transistors are connected to a same gate line, and
   the two first transistors have a different conductivity type from a conductivity type of the two second transistors.
Clause 4. The semiconductor memory device of any of clauses 1-3, further comprising:
   two third transistors, a first one of the two third transistors being connected to the first global bit line of the first cell region and a second one of the two third transistors being connected to the first global bit line of the second cell region, and the two third transistors being configured to provide a pre-charge voltage to the first global bit line of the first cell region and to the first global bit line of the second cell region, and
   two fourth transistors, a first one of the two fourth transistors being connected to the second global bit line of the first cell region and a second one of the two fourth transistors being connected to the second global bit line of the second cell region, and the two fourth transistors being configured to provide the pre-charge voltage to the second global bit line of the first cell region and to the second global bit line of the second cell region,
   wherein gates of the first one of the two first transistors and the first one of the two fourth transistors are connected to a first gate line, and
   gates of the first one of the two second transistors and gates of the first one of the two third transistors connected to a second gate line.
Clause 5. The semiconductor memory device of any of clauses 1 to 4,
   wherein memory cells that are spaced apart in the vertical direction are connected to each of the first local bit lines and the second local bit lines of each of the first cell region and the second cell regions.
Clause 6. A semiconductor memory device comprising:
   first global bit lines and second global bit lines which extend in a first horizontal direction, the first global bit lines being arranged alternately with the second global bit lines along a second horizontal direction;
   first local bit lines that extend in a vertical direction, each of the first global bit lines being connected to one or more of the first local bit lines;
   second local bit lines that extend in the vertical direction, each of the second global bit lines being connected to one or more of the second local bit lines;
   first transistors, each of the first global bit lines being connected to a corresponding one of the first transistors;
   second transistors, each of the second global bit lines being connected to a corresponding one of the second transistors, the first transistors being arranged alternatively with the second transistors to correspond to an arrangement of the first global bit lines and the second global bit lines and to form adjacent pairs; and
   sense amplifiers, each adjacent pair of the first transistors and the second transistors being connected to a corresponding one of the sense amplifiers,
   wherein the semiconductor memory device is configured such that when the first transistors are turned on and the second transistors are turned off, the second global bit lines are in a floating status or a pre-charged status, and
   wherein the semiconductor memory device is configured such that when the second transistors are turned on and the first transistors are turned off, the first global bit lines are in the floating status or the pre-charged status.
Clause 7. The semiconductor memory device of clause 6, further comprising:
   third transistors configured to provide a pre-charge voltage to each of corresponding ones of the first global bit lines, and
   fourth transistors configured to provide the pre-charge voltage to each corresponding ones of the second global bit lines,
   wherein a gate of the third transistors are connected to a gate of the second transistors, respectively, and
   a gate of the fourth transistors are connected to a gate of the first transistors, respectively.
Clause 8. The semiconductor memory device of clause 6,
   wherein the gates of the first transistors are connected to the gates of the second transistors, and
   the first transistors have a different conductivity type than a conductivity type of and the second transistors are transistors of different conductivity types from each other.

## Claims

1. A semiconductor memory device comprising:
a cell structure (CS); and
a peripheral circuit structure (PS) on the cell structure (CS),
wherein the cell structure (CS) includes:
first local bit lines (LBL1) which extend in a vertical direction (DR3) on a first substrate (100), and are spaced apart in a first horizontal direction (DR1),
second local bit lines (LBL2) which extend in the vertical direction (DR3) on the first substrate (100), and are spaced apart from the first local bit lines in a second horizontal direction (DR2),
a first global bit line (GBL1) which extends in the first horizontal direction (DR1), and is electrically connected to the first local bit lines (LBL1), and
a second global bit line (GBL2) which extends in the first horizontal direction (DR1), and is electrically connected to the second local bit lines (LBL2),
wherein the peripheral circuit structure (PS) includes:
a peripheral circuit transistor (PTR) on a second substrate (200),
a first transistor (STR1) which is electrically connected to the peripheral circuit transistor (PTR) on the second substrate (200) and the first global bit line (GBL1), and
a second transistor (STR2) which is electrically connected to the peripheral circuit transistor (PTR) on the second substrate (200) and the second global bit line (GBL2),
wherein the semiconductor memory device is configured to selectively turn on the first transistor (STR1) and the second transistor (STR2) in a complementary manner.

2. The semiconductor memory device of claim 1, wherein the peripheral circuit structure (PS) further includes:
a first gate line (G1) which is electrically connected to a gate of the first transistor (STR1), and
a second gate line (G2) which is electrically connected to a gate of the second transistor (STR2) and is different from the first gate line (G1).

3. The semiconductor memory device of claim 1 or claim 2, wherein the peripheral circuit structure (PS) further includes:
a wiring to which a pre-charge voltage (Vpre) is provided,
a third transistor electrically (STR3) connected to the wiring on the second substrate (200) and to the first global bit line (GBL1),
a fourth transistor (STR4) electrically connected to the wiring on the second substrate (200) and to the second global bit line (GBL2),
a first gate line (G1) electrically connected to a gate of the first transistor (STR1) and to a gate of the fourth transistor (STR4), and
a second gate line (G2) electrically connected to a gate of the second transistor (STR2) and to a gate of the third transistor (STR3).

4. The semiconductor memory device of any preceding claim,
wherein the first global bit line (GBL1), the second global bit line (GBL2), the peripheral circuit transistor (PTR), the first transistor (STR1), and the second transistor (STR2) are provided in plural numbers,
the plurality of first global bit lines (GBL1) are arranged alternately with the plurality of second global bit lines (GBL2) along the second horizontal direction (DR2),
each of the plurality of first transistors (STR1) is electrically connected to a corresponding peripheral circuit transistor (PTR) of the plurality of peripheral circuit transistors (PTR) and to a corresponding first global bit line (GBL1) of the plurality of first global bit lines (GBL1), and
each of the plurality of second transistors (STR2) is electrically connected to a corresponding peripheral circuit transistor (PTR) of the plurality of peripheral circuit transistors (PTR) and to a corresponding second global bit line (GBL2) of the plurality of second global bit lines (GBL2).

5. The semiconductor memory device of claim 4,
wherein the peripheral circuit structure (PS) further includes a first gate line (G1) extending in the second horizontal direction (DR2) and electrically connected to gates of the plurality of first transistors (STR1), and
a second gate line (G2) extending in the second horizontal direction (DR2) and electrically connected to gates of the plurality of second transistors (STR2).

6. The semiconductor memory device of any preceding claim,
wherein the cell structure (CS) includes a first cell region (CR1) and a second cell region (CR2) which are spaced apart in the first horizontal direction (DR1) and which each include the first local bit lines (LBL1), the second local bit lines (LBL2), the first global bit line (GBL1), and the second global bit line (GBL2), and are spaced apart in the first horizontal direction (DR1), and
the first global bit line (GBL1) and the second global bit line (GBL2) of the first cell region (CR1), and the first global bit line (GBL1) and the second global bit line (GBL2) of the second cell region (CR2) are electrically connected to the peripheral circuit transistor (PTR).

7. The semiconductor memory device of any preceding claim,
wherein the cell structure (CS) further comprises:
a semiconductor pattern (SP) connected to each of the first local bit lines (LBL1) and to each of the second local bit lines (LBL2), the semiconductor pattern (SP) extending in the first horizontal direction (DR1),
a word line (WL) extending in the second horizontal direction (DR2) on the semiconductor pattern (SP), and
a data storage element (CAP) connected to the semiconductor pattern (SP).

8. The semiconductor memory device of any preceding claim,
wherein the first substrate (100) includes a first side (100a) and a second side (100b) that are opposite to each other in the vertical direction (DR3),
the second substrate (200) includes a third side (200a) and a fourth side (200b) that are opposite to each other in the vertical direction (DR3),
the first local bit lines (LBL1) and the second local bit lines (LBL2) and the first global bit line (GBL1) and the second global bit line (GBL2) are disposed on the first side (100a) of the first substrate (100),
the first transistor (STR1), the second transistor (STR2), and the peripheral circuit transistor (PTR) are disposed on the third side (200a) of the second substrate (200), and
the first side (100a) of the first substrate (100) is opposite to the fourth side (200b) of the second substrate (200).

9. The semiconductor memory device of any preceding claim,
wherein the peripheral circuit structure (PS) further includes a first through via (220) and a second through via (220) that penetrates the second substrate (200), and
the first global bit line (GBL1) is electrically connected to the first transistor (STR1) through the first through via (220), and the second global bit line (GBL2) is electrically connected to the second transistor (STR2) through the second through via (220).

10. The semiconductor memory device of any preceding claim,
wherein the cell structure (CS) further includes a first bonding pad (166) electrically connected to the first global bit line (GBL1) and to the second global bit line (GBL2),
the peripheral circuit structure (PS) further includes a second bonding pad (266) electrically connected to the first transistor (STR1) and to the second transistor (STR2), and
the first bonding pad (166) and the second bonding pad (266) are in contact with each other.

11. The semiconductor memory device of claim 10,
wherein the peripheral circuit structure (PS) further includes a through via (220) that penetrates the second substrate (200) and is electrically connected to the second bonding pad (266).

12. The semiconductor memory device of claim 1,
wherein the peripheral circuit structure (PS) further includes a gate line (G) that extends in the second horizontal direction (DR2) and is electrically connected to a gate of the first transistor (STR1) and to a gate of the second transistor (STR2).

13. A semiconductor memory device comprising:
a first cell region (CR1) and a second cell region (CR2) which each include a first global bit line (GBL1) to which first local bit lines (LBL1) extending in a vertical direction (DR3) are connected, and a second global bit line (GBL2) to which second local bit lines (LBL2) extending in the vertical direction (DR3) are connected;
a sense amplifier (SA) to which the first global bit line (GBL1) and the second global bit line (GBL2) of the first cell region (CR1) and the first global bit line (GBL1) and the second global bit line (GBL2) of the second cell region (CR2) are commonly connected;
two first transistors (STR1), a first one of the two first transistors (STR1) being connected between the first global bit line (GBL1) of the first cell region (CR1) and the sense amplifier (SA), and a second one of the two first transistors (STR1) being connected between the first global bit line (GBL1) of the second cell region (CR2) and the sense amplifier (SA); and
two second transistors (STR2), a first one of the two second transistors (STR2) being connected between the second global bit line (GBL2) of the first cell region (CR1) and the sense amplifier (SA), and a second one of the two second transistors (STR2) being connected between the second global bit line (GBL2) of the second cell region (CR2) and the sense amplifier (SA),
wherein the semiconductor memory device is configured to selectively turn on the two first transistors (STR1) with respect to the two second transistors (STR2) in a complementary manner.

14. The semiconductor memory device of claim 13, further comprising:
two third transistors (STR3), a first one of the two third transistors (STR3) being connected to the first global bit line (GBL1) of the first cell region (CR1) and a second one of the two third transistors (STR3) being connected to the first global bit line (GBL1) of the second cell region (CR2), and the two third transistors (STR3) providing a pre-charge voltage (Vpre) to the first global bit line (GBL1) of the first cell region (CR1) and to the first global bit line (GBL1) of the second cell region (CR2), and
two fourth transistors (STR4), a first one of the two fourth transistors (STR4) being connected to the second global bit line (GBL2) of the first cell region (CR1) and a second one of the two fourth transistors (STR4) being connected to the second global bit line (GBL2) of the second cell region (CR2), and the two fourth transistors (STR4) providing the pre-charge voltage (Vpre) to the second global bit line (GBL2) of the first cell region (CR1) and to the second global bit line (GBL2) of the second cell region (CR2),
wherein gates of the first one of the two first transistors (STR2) and gates of the first one of the two fourth transistors (STR4) are connected to a first gate line (G1), and
gates of the first one of the two second transistors (STR2) and gates of the first one of the two third transistors (STR3) are connected to a second gate line (G2).

15. A semiconductor memory device comprising:
first global bit lines (GBL1) and second global bit lines (GBL2) which extend in a first horizontal direction (DR1), the first global bit lines (GBL1) being arranged alternately with the second global bit lines (GBL2) along a second horizontal direction (DR2);
first local bit lines (LBL1) that extend in a vertical direction (DR3), each of the first global bit lines (GBL1) being connected to one or more of the first local bit lines (LBL1);
second local bit lines (LBL2) that extend in the vertical direction (DR3), each of the second global bit lines (GBL2) being connected to one or more of the second local bit lines (LBL2);
first transistors (STR1), each of the first global bit lines (GBL1) being connected to a corresponding one of the first transistors (STR1);
second transistors (STR2), each of the second global bit lines (GBL2) being connected to a corresponding one of the second transistors (STR2), the first transistors (STR1) being arranged alternatively with the second transistors (STR2) to correspond to an arrangement of the first global bit lines (GBL1) and the second global bit lines (GBL2) and to form adjacent pairs; and
sense amplifiers (SA), each adjacent pair of the first transistors (STR1) and the second transistors (STR2) being connected to a corresponding one of the sense amplifiers (SA),
wherein the semiconductor memory device is configured such that when the first transistors (STR1) are turned on and the second transistors (STR2) are turned off, the second global bit lines (GBL2) are in a floating status or a pre-charged status, and
the semiconductor memory device is configured such that when the second transistors (STR2) are turned on and the first transistors (STR1) are turned off, the first global bit lines (GBL1) are in the floating status or the pre-charged status.
